# EUROPEAN PATENT APPLICATION

(11) **EP 4 145 156 A1**
(43) Date of publication of application: **08.03.2023**
(21) Application number: 22186301.2
(22) Date of filing: 21.07.2022
(51) Int. Cl.: G01R 31/389, G01R 31/396

(54) **BATTERY PACK MONITORING METHOD, APPARATUS, AND DEVICE, AND COMPUTER-READABLE STORAGE MEDIUM**

(30) Priority: 03.09.2021 HK 32021038204
(71) Applicant: Yeung, Kam Fai, Kowloon (HK)
(72) Inventor: Yeung, Kam Fai, Kowloon (HK)
(74) Representative: Izquierdo Blanco, Maria Alicia

(57) **Abstract**

The present invention provides a battery pack monitoring method, apparatus, and device, and a computer-readable storage medium. The method includes: acquiring current information of a battery pack collected by a current measurement unit in real time; acquiring voltage information of each battery cell in the battery pack collected by a voltage measurement unit in real time, wherein time points of the current information coincide with respective time points of the voltage information; determining whether a difference between the current information at a present time point and the current information at a preceding time point is greater than a predetermined value; and establishing a battery monitoring model and generating an internal impedance value of each battery cell according to the battery monitoring model in response to determining that the difference is greater than the predetermined value. The present invention aims at monitoring batteries in real time without damaging the batteries.

## Description

### TECHNICAL FIELD

The present invention relates to the field of backup battery monitoring, in particular to a battery pack monitoring method, apparatus, and device, and a computer-readable storage medium.

### BACKGROUND

A large number of batteries are required in a backup power system and these batteries need to be constantly monitored so as to work as required. An alarm will be given if any indication of abnormality is detected, so that maintenance can be performed in time to prevent failures. During battery monitoring, an important parameter to monitor is an internal impedance of the battery, which reflects the health, service life and capacity of the battery. The internal impedance of the battery cannot be measured when the battery is in a steady state, and can only be measured when the battery experiences voltage and current changes. In a conventional measurement method, an instantaneous load is provided for the battery or an instantaneous alternating current is injected, and then voltage and current changes are measured, based on which the internal impedance of the battery is calculated. However, this method is invasive measurement, which will do certain harm to the service life of the battery and therefore should not be used frequently. If a battery string is long subjected to such an invasive internal impedance measurement method, even a small current difference will cause battery failures due to an accumulative effect over time.

In view of this, this application is hereby filed.

### SUMMARY

The present invention discloses a battery pack monitoring method, apparatus, and device, and a computer-readable storage medium, aiming at monitoring batteries in real time without damaging the batteries.

A first embodiment of the present invention provides a battery pack monitoring method, including:
acquiring current information of a battery pack collected by a current measurement unit in real time;
acquiring voltage information of each battery cell in the battery pack collected by a voltage measurement unit in real time, time points of the current information coincide with respective time points of the voltage information;
determining whether a difference between the current information at a present time point and the current information at a preceding time point is greater than a predetermined value; and
establishing a battery monitoring model and generating an internal impedance value of each battery cell according to the battery monitoring model in response to determining that the difference is greater than the predetermined value.

Optionally, the method further includes: broadcasting synchronization signals to the current measurement unit and the voltage measurement unit at predetermined time intervals to ensure time synchronization between the current measurement unit and the voltage measurement unit.

Optionally, establishing a battery monitoring model and generating an internal impedance value of each battery cell according to the battery monitoring model in response to determining that the difference is greater than the predetermined value specifically comprises:
calling the voltage information V2 and the current information A2 at the present time point and the voltage information VI and the current information A1 at the preceding time point to establish a battery internal impedance measurement model: R = (V1-V2)/(A1-A2); and generating the internal impedance value R of each battery cell by calculation.

Optionally, the battery monitoring model further comprises: a capacitance measurement model and an inductance measurement model.

A second embodiment of the present invention provides a battery pack monitoring apparatus, including:
a current information acquisition unit configured to acquire current information of a battery pack collected by a current measurement unit in real time;
a voltage information acquisition unit configured to acquire voltage information of each battery cell in the battery pack collected by a voltage measurement unit in real time, wherein time points of the current information coincide with respective time points of the voltage information;
a determination unit configured to determine whether a difference between the current information at a present time point and the current information at a preceding time point is greater than a predetermined value; and
a battery monitoring model establishment unit configured to establish a battery monitoring model and generate an internal impedance value of each battery cell according to the battery monitoring model in response to determining that the difference is greater than the predetermined value.

Optionally, the apparatus further includes: broadcasting synchronization signals to the current measurement unit and the voltage measurement unit at predetermined time intervals to ensure time synchronization between the current measurement unit and the voltage measurement unit.

Optionally, the battery monitoring model establishment unit is specifically configured to:
call the voltage information V2 and the current information A2 at the present time point and the voltage information VI and the current information A1 at the preceding time point to establish a battery internal impedance measurement model: R = (V1-V2)/(A1-A2); and generate the internal impedance value R of each battery cell by calculation.

Optionally, the battery monitoring model further comprises: a capacitance measurement model and an inductance measurement model.

A third embodiment of the present invention provides a battery pack monitoring device, including a processor, a memory, and a computer program stored in the memory and configured to be executed by the processor to cause the processor to implement any one of the battery pack monitoring methods described above.

A fourth embodiment of the present invention provides a computer-readable storage medium storing a computer program which can be executed by a processor of a device in which the computer-readable storage medium is located to implement any one of the battery pack monitoring methods described above.

According to the battery pack monitoring method, apparatus, and device, and the computer-readable storage medium provided by the invention, the current information and the voltage information are acquired in real time through the current measurement unit and the voltage measurement unit, respectively, and current information at each time point corresponds to respective voltage information; when a change of the current information is greater than the predetermined value, the battery monitoring model is established to obtain the internal impedance value of each battery cell in the battery pack; in this way, the internal impedance value of the battery cell in the battery pack is measured without adding any load or injecting any voltage or current, thus prolonging the service life of the battery pack.

### BRIEF DESCRIPTION OF DRAWINGS

Fig. 1 is a flowchart of a battery pack monitoring method according to a first embodiment of the present invention;
Fig. 2 is a modular block diagram of a battery monitoring system according to the present invention;
Fig. 3 is a schematic diagram of a circuit of a battery cell of a battery pack according to the present invention; and
Fig. 4 is a modular block diagram of a battery pack monitoring apparatus according to a second embodiment of the present invention.

### DETAILED DESCRIPTION

The technical schemes in the embodiments of the present invention are clearly and completely described in the following with reference to the drawings in the embodiments of the present invention. It is obvious that the described embodiments are only some of the embodiments of the present invention and are not all the embodiments. All other embodiments obtained by those of ordinary skill in the art based on the embodiments of the present invention without inventive effort are within the scope of the present invention.

In order to better understand the technical solution of the present invention, the embodiments of the present invention are described in detail below with reference to the accompanying drawings.

It should be clear that the described embodiments are only some of the embodiments of the present invention instead of all the embodiments thereof. All other embodiments obtained by those of ordinary skill in the art based on the embodiments of the present invention without inventive effort fall within the scope of protection of the present invention.

Terms used in embodiments of the present invention are for the purpose of describing specific embodiments only and are not intended to limit the present invention. The singular forms "a/an" and "the" as used in the embodiments of the present invention and in the appended claims are also intended to include the plural forms, unless the context clearly dictates otherwise.

It should be understood that the term "and/or" used herein is merely an association relationship that describes associated objects, and represents that there may be three kinds of relationships. For example, A and/or B may represent three cases: only A exists, both A and B exist, and only B exists. In addition, the slash "/" used herein generally indicates that associated objects are in an "or" relationship.

Depending on the context, the word "if' as used herein may be interpreted as "once" or "when" or "in response to determining that" or "in response to detecting that". Similarly, depending on the context, the phrases "if it is determined that" or "if it is detected that (stated condition or event)" can be interpreted as "when it is determined that" or "in response to determining that" or "when it is detected that" or "in response to detecting that (stated condition or event)".

The reference to "first\ second" in the embodiment is merely to distinguish similar objects and does not represent a specific order for the objects, and it is understood that "first\ second" may be interchanged in a specific order or sequence if permitted. It should be understood that the objects distinguished by "first\ second" are interchangeable where appropriate, such that the embodiments described herein can be implemented in an order other than those illustrated or described herein.

Specific embodiments of the present invention are described in detail below with reference to the accompanying drawings.

The present invention discloses a battery pack monitoring method, apparatus, and device, and a computer-readable storage medium, aiming at monitoring batteries in real time without damaging the batteries.

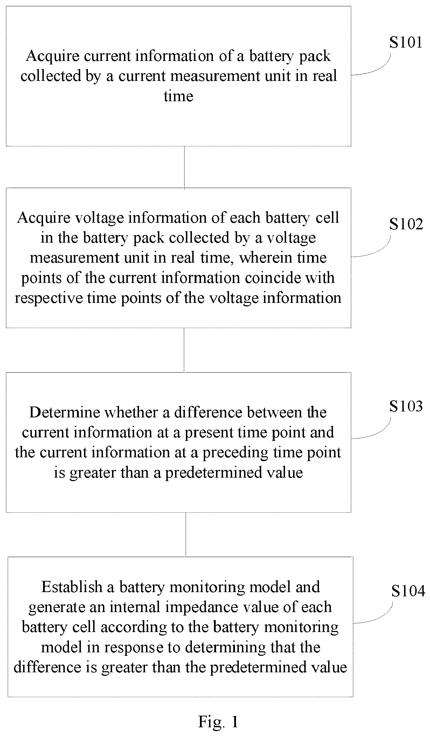

Referring to Fig. 1, a first embodiment of the present invention provides a battery pack monitoring method which can be executed by a battery pack monitoring device (hereinafter referred to as monitoring device), in particular, by one or more processors in the monitoring device to implement the following steps.

At S101, current information of a battery pack collected by a current measurement unit in real time is acquired.

In this embodiment, the monitoring device may be a cloud-based server or a user terminal device (such as a smart phone, a smart printer or other smart devices), wherein the monitoring device may store a computer program for measuring the internal impedance value of each battery cell in the battery pack.

In this embodiment, the monitoring device is a sync generator, which can communicate with the current measurement unit and the voltage measurement unit through a wireless network, and of course, may also be connected to the current measurement unit and the voltage measurement unit through a communication line for data transmission, which is not specifically limited here, but these schemes are within the scope of protection of the present invention.

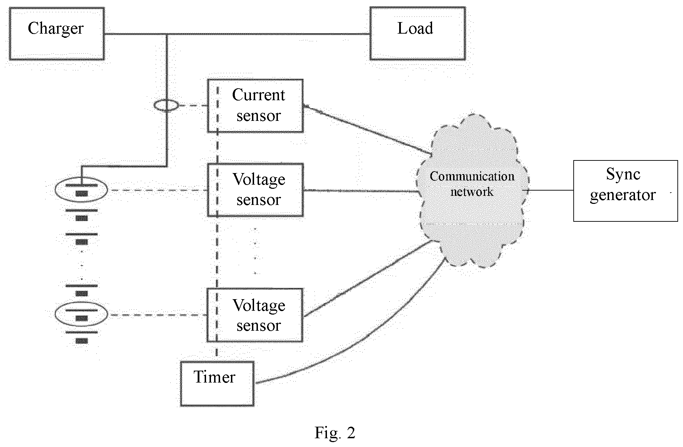

Referring to Fig. 2, it should be noted that, in this embodiment, the battery pack is formed by at least two battery cells connected in series, and the currents flowing through the battery cells are the same. The current measurement unit may be a current sensor arranged in a circuit, which is configured to collect the current in the circuit in real time. It should be understood that collected current data may be sent to the sync generator in a wired or wireless manner. In this embodiment, The voltage sensor and the current sensor may be connected to a node in a communication network, so as to communicate with the sync generator.

At S102, voltage information of each battery cell in the battery pack collected by a voltage measurement unit in real time is acquired, wherein time points of the current information coincide with respective time points of the voltage information.

It should be noted that, in this embodiment, the voltage measurement unit may be a voltage sensor connected to each battery cell and configured to collect voltage data of each battery cell in real time, and the voltage data may be sent to the sync generator in a wired or wireless manner. Specifically, in this embodiment, time points of the voltage data and time points of the current data have a one-to-one correspondence. For example, if the current sensor collects current data A1 at 12:30, then there will be corresponding voltage data VI also collected at 12:30.

At S103, it is determined whether a difference between the current information at a present time point and the current information at a preceding time point is greater than a predetermined value.

In this embodiment, the current sensor collects current data A1 at 12:30 and current data A2 at 12:31, wherein both A1 and A2 will be uploaded to the sync generator, and in response to determining that a difference between A1 and A2 is greater than the predetermined value, a battery monitoring model is established. It should be understood that, in other embodiments, the monitoring model can also be established based on other conditions, which is not limited here, but these schemes are all within the scope of protection of the present invention.

At S104, in response to determining that the difference is greater than the predetermined value, a battery monitoring model is established and an internal impedance value of the battery cell is generated according to the battery monitoring model.

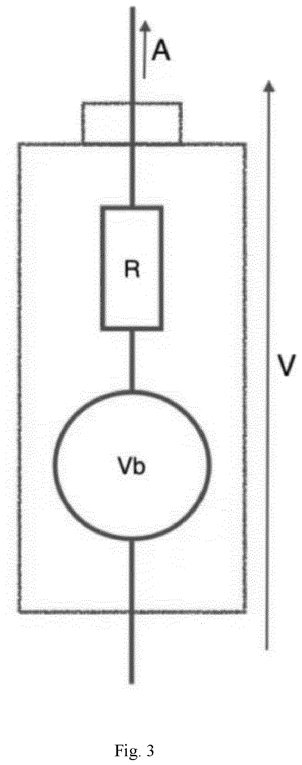

Specifically, referring to Fig. 3 which is a schematic diagram of a battery cell, in this embodiment, in response to determining that the difference between A1 and A2 is greater than the predetermined value, the voltage information V2 and the current information A2 at the present time point and the voltage information VI and the current information A1 at the preceding time point are called to establish a battery internal impedance measurement model: R = (V1-V2)/(A1-A2); and then the internal impedance value R of the battery cell is generated by calculation. It should be understood that in this embodiment, no invasive measurement is performed on the battery, and the internal impedance value of the battery is obtained without adding any load or injecting any voltage or current, which effectively avoids the problem that the service life of the battery is reduced due to measurement.

In this embodiment, the method further includes: broadcasting synchronization signals to the current measurement unit and the voltage measurement unit at predetermined time intervals to ensure time synchronization between the current measurement unit and the voltage measurement unit.

It should be noted that the sync generator can send synchronization signals every 10 seconds (but not limited to this), so that the current sensor and the voltage sensor connected in a wired or wireless manner can collect the voltage data and the current data synchronously, and the synchronization error can be less than 0.1 ms.

In this embodiment, the battery monitoring model further comprises: a capacitance measurement model and an inductance measurement model.

It should be noted that after a series of voltage data and current data of the battery at same time points are collected, the internal impedance value of the battery can be accurately measured based on the exact time interval between different sets of data. When capacitance or inductance in the circuit needs to be measured, a capacitance measurement model and an inductance measurement model can be established. Of course, in other embodiments, other models may also be included, which is not limited here, but these schemes are all within the scope of protection of the present invention.

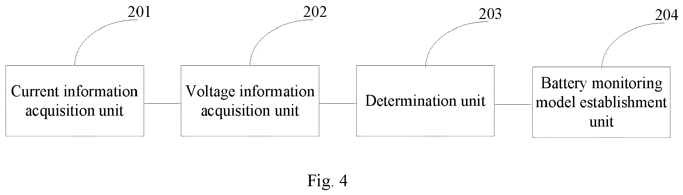

Referring to Fig. 4, a second embodiment of the present invention provides a battery pack monitoring apparatus, including:
a current information acquisition unit 201 configured to acquire current information of a battery pack collected by a current measurement unit in real time;
a voltage information acquisition unit 202 configured to acquire voltage information of each battery cell in the battery pack collected by a voltage measurement unit in real time, wherein time points of the current information coincide with respective time points of the voltage information;
a determination unit 203 configured to determine whether a difference between the current information at a present time point and the current information at a preceding time point is greater than a predetermined value; and
a battery monitoring model establishment unit 204 configured to establish a battery monitoring model and generate an internal impedance value of each battery cell according to the battery monitoring model in response to determining that the difference is greater than the predetermined value.

Optionally, the apparatus further includes: broadcasting synchronization signals to the current measurement unit and the voltage measurement unit at predetermined time intervals to ensure time synchronization between the current measurement unit and the voltage measurement unit.

Optionally, the battery monitoring model establishment unit 204 is specifically configured to:
call the voltage information V2 and the current information A2 at the present time point and the voltage information VI and the current information A1 at the preceding time point to establish a battery internal impedance measurement model: R = (V1-V2)/(A1-A2); and generate the internal impedance value R of each battery cell by calculation.

Optionally, the battery monitoring model further comprises: a capacitance measurement model and an inductance measurement model.

A third embodiment of the present invention provides a battery pack monitoring device, including a processor, a memory, and a computer program stored in the memory and configured to be executed by the processor to cause the processor to implement any one of the battery pack monitoring methods described above.

A fourth embodiment of the present invention provides a computer-readable storage medium storing a computer program which can be executed by a processor of a device in which the computer-readable storage medium is located to implement any one of the battery pack monitoring methods described above.

According to the battery pack monitoring method, apparatus, and device, and the computer-readable storage medium provided by the invention, the current information and the voltage information are acquired in real time through the current measurement unit and the voltage measurement unit, respectively, and current information at each time point corresponds to respective voltage information; when a change of the current information is greater than the predetermined value, the battery monitoring model is established to obtain the internal impedance value of each battery cell in the battery pack; in this way, the internal impedance value of the battery cell in the battery pack is measured without adding any load or injecting any voltage or current, thus prolonging the service life of the battery pack.

By way of example, the computer program described in the third and fourth embodiments of the present invention may be divided into one or more modules stored in the memory and executed by the processor to implement the present invention. The one or more modules may be a series of computer program instruction segments capable of performing specific functions, and the instruction segments are configured to describe the execution process of the computer program in the battery pack monitoring device. For example, the apparatus described in the second embodiment of the present invention.

The processor may be a central processing unit (CPU), or other general purpose processors, a digital signal processor (DSP), an application-specific integrated circuit (ASIC), a field-programmable gate array (FPGA), or other programmable logic devices, discrete gates or transistor logic devices, discrete hardware components, etc. The general purpose processor may be a microprocessor, or the processor may be any conventional processor. The processor is a control center of the battery pack monitoring method, using various interfaces and circuits to connect various parts that are configured to implement the battery pack monitoring method.

The memory may be configured to store the computer programs and/or modules, and the processor can implement various functions of the battery pack monitoring method by running or executing the computer programs and/or modules stored in the memory and calling the data stored in the memory. The memory may mainly include a storage program area and a storage data area, wherein the stored program area may store an operating system and application program(s) required by at least one function (such as an audio playback function and a text conversion function), etc.; and the storage data area can store data (such as audio data, text message data, etc.) created from the use of a mobile phone. In addition, the memory may be a high-speed random access memory, or a non-volatile memory, such as hard disk, internal storage, plug-in hard disk, smart media card (SMC), secure digital (SD) card, flash card, at least one disk memory device, flash memory device, or other volatile solid-state memory devices.

Herein, if the implemented modules are implemented in the form of functional units of software and sold or used as independent products, they can be stored in a computer-readable storage medium. Based on this understanding, all or part of the processes of the methods in the above embodiments may also be completed by related hardware with instructions of a computer program which computer program may be stored in a computer-readable storage medium, and when executed by a processor, the computer program can implement the steps of the above methods. Herein, the computer program includes computer program code, which may be in the form of source code, object code, an executable file or in some intermediate forms, etc. The computer-readable medium may include: any entity or device capable of carrying computer program codes, a recording medium, a USB flash drive, a removable hard disk, a magnetic disk, an optical disk, a computer memory, a read-only memory (ROM), a random access memory (RAM), an electrical carrier signal, a telecommunication signal, a software distribution medium, etc. It should be noted that the contents contained in the computer-readable medium can be appropriately added or subtracted according to the requirements of legislation and patent practice in jurisdictions. For example, in some jurisdictions, according to legislation and patent practice, the computer-readable medium does not include electrical carrier signals and telecommunication signals.

It should be noted that the apparatus embodiments described above are only for illustration. The units described as separate components may or may not be physically separated, and the components displayed as units may or may not be physical units, that is, they may be located in one place or distributed to multiple network units. Some or all of the modules may be selected according to actual needs to achieve the purpose of this embodiment. In addition, in the figures of apparatus embodiments provided by the present invention, the connection between modules means that they are in communication, which can be specifically realized as one or more communication buses or signal wires. Those of ordinary skill in the art can understand and implement it without creative labor.

Only a preferred embodiment of the present invention is described above, and the scope of protection of the present invention is not limited thereto. Any changes or substitutions that can be readily conceived by those skilled in the art within the technical scope disclosed by the present invention shall fall within the scope of protection of the present invention. Therefore, the scope of protection of the present invention should be subject to the scope of protection of the claims.

## Claims

1. A battery pack monitoring method, comprising:
acquiring current information of a battery pack collected by a current measurement unit in real time;
acquiring voltage information of each battery cell in the battery pack collected by a voltage measurement unit in real time, wherein time points of the current information coincide with respective time points of the voltage information;
determining whether a difference between the current information at a present time point and the current information at a preceding time point is greater than a predetermined value; and
establishing a battery monitoring model and generating an internal impedance value of each battery cell according to the battery monitoring model in response to determining that the difference is greater than the predetermined value.

2. The battery pack monitoring method of claim 1, further comprising: broadcasting synchronization signals to the current measurement unit and the voltage measurement unit at predetermined time intervals to ensure time synchronization between the current measurement unit and the voltage measurement unit.

3. The battery pack monitoring method of claim 1, wherein establishing a battery monitoring model and generating an internal impedance value of each battery cell according to the battery monitoring model in response to determining that the difference is greater than the predetermined value specifically comprises:
calling the voltage information V2 and the current information A2 at the present time point and the voltage information VI and the current information A1 at the preceding time point to establish a battery internal impedance measurement model: R = (V1-V2)/(A1-A2); and generating the internal impedance value R of each battery cell by calculation.

4. The battery pack monitoring method of claim 3, wherein the battery monitoring model further comprises: a capacitance measurement model and an inductance measurement model.

5. A battery pack monitoring apparatus, comprising:
a current information acquisition unit configured to acquire current information of a battery pack collected by a current measurement unit in real time;
a voltage information acquisition unit configured to acquire voltage information of each battery cell in the battery pack collected by a voltage measurement unit in real time, wherein time points of the current information coincide with respective time points of the voltage information;
a determination unit configured to determine whether a difference between the current information at a present time point and the current information at a preceding time point is greater than a predetermined value; and
a battery monitoring model establishment unit configured to establish a battery monitoring model and generate an internal impedance value of each battery cell according to the battery monitoring model in response to determining that the difference is greater than the predetermined value.

6. The battery pack monitoring apparatus of claim 5, further comprising: broadcasting synchronization signals to the current measurement unit and the voltage measurement unit at predetermined time intervals to ensure time synchronization between the current measurement unit and the voltage measurement unit.

7. The battery pack monitoring apparatus of claim 5, wherein the battery monitoring model establishment unit is specifically configured to:
call the voltage information V2 and the current information A2 at the present time point and the voltage information VI and the current information A1 at the preceding time point to establish a battery internal impedance measurement model: R = (V1-V2)/(A1-A2); and generate the internal impedance value R of each battery cell by calculation.

8. The battery pack monitoring apparatus of claim 7, wherein the battery monitoring model further comprises: a capacitance measurement model and an inductance measurement model.

9. A battery pack monitoring device, comprising a processor, a memory, and a computer program stored in the memory and configured to be executed by the processor to cause the processor to implement the battery pack monitoring method of any one of claims 1-4.

10. A computer-readable storage medium storing a computer program which is executable by a processor of a device in which the computer-readable storage medium is located to implement the battery pack monitoring method of any one of claims 1-4.
